# EUROPEAN PATENT APPLICATION

(11) **EP 2 312 647 A1**
(43) Date of publication of application: **20.04.2011**
(21) Application number: 09802934.1
(22) Date of filing: 28.07.2009
(51) Int. Cl.: H01L 31/042

(54) **SOLAR CELL MODULE**

(30) Priority: 30.07.2008 JP 2008196732
(71) Applicant: Sharp Kabushiki Kaisha, Osaka-shi, Osaka 545-8522 (JP)
(72) Inventor: NAITOH, Katsuyuki, Osaka 545-8522 (JP); WATANABE, Ryutarou, Osaka 545-8522 (JP)
(74) Representative: Müller - Hoffmann & Partner
(86) International application number: PCT/JP2009/063386
(87) International publication number: WO 2010/013691

(57) **Abstract**

In one embodiment of a solar cell module having a configuration in which at least one module support member (30) is bonded with an adhesive (40) to a back film (25) of a solar cell module main body (10), a corner portion (38, 39) formed by a bottom face (35) of the module support member (30) that faces the back film (25) and each side face (36, 37) of the module support member is formed in a cut-out shape such as an R-chamfered shape, a C-chamfered shape, and a stepped shape, and an area including a cut-out part of the corner portion (38, 39) and up to each side face (36, 37) is covered with the adhesive (40).

## Description

### Technical Field

The present invention relates to a solar cell module.

### Background Art

Conventional thin-film solar cell modules are used while being fitted in a frame body in order to have dynamic strength and weather resistance due to an increase in panel areas. In this case, although techniques such as increasing the plate thickness of the frame body, increasing the thicknesses of panel constituent members, and using special tempered glass have been employed in order to maintain the strength of solar cell modules, there is the problem that the overall weight increases or the cost of the constituent members increases. In addition, if the thickness of the surface substrate (translucent resin substrate) of a solar cell module is increased in order to attain the required strength, there is the problem that photoelectric conversion efficiency is reduced because of a decrease in the amount of incident light.

In view of this, techniques have heretofore been proposed that can solve the above-described problems and enable a solar cell module to maintain its dynamic strength with little increase in the thickness of the constituent members of the solar cell module (see Patent Document 1, for example).

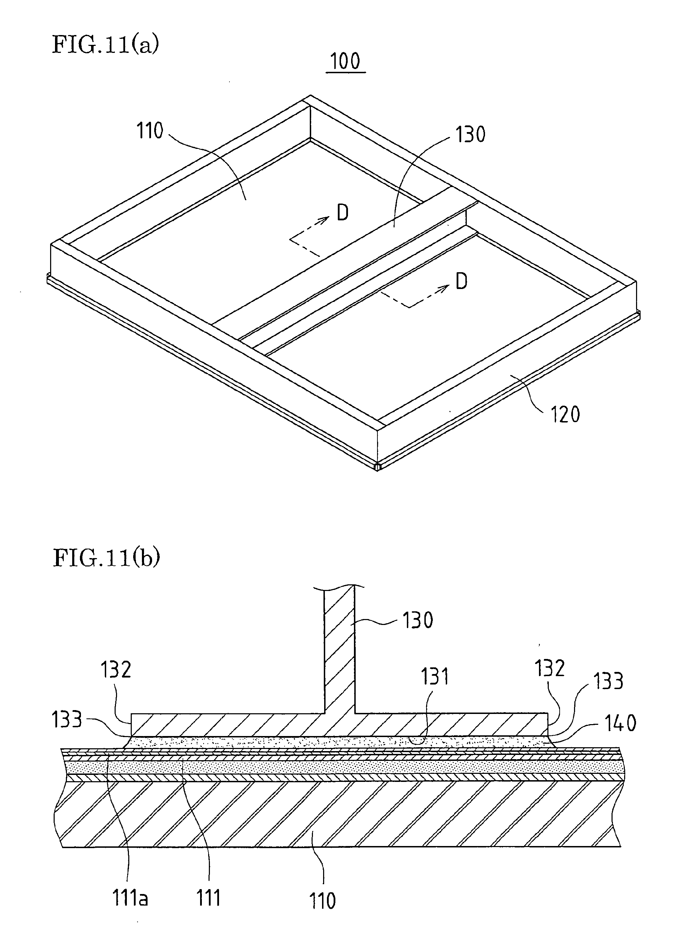

FIG. 11(a) is a perspective view showing an example of the overall configuration of such a conventional solar cell module, and FIG. 11(b) is a cross-sectional view taken along line D-D in FIG. 11(a).

A conventional solar cell module 100 is configured by a solar cell module main body 110, a frame body 120 that surrounds and holds the solar cell module main body, and a module support member 130 that is fixed at its both end portions to the frame body 120. The module support member 130 is formed in the shape of the letter H, and a bottom face 131 of the module support member 130 and a back face of the solar cell module main body 110 are bonded and fixed to each other with an adhesive 140.

Specifically, the conventional solar cell module 100 has a configuration in which the module support member 130 is provided so as to maintain the dynamic strength of the solar cell module with little increase in the thickness of the constituent members of the solar cell module.

### Prior Art Document

### Patent Document

[Patent Document 1] JP 10-294485A

### Summary of Invention

### Problem to be Solved by the Invention

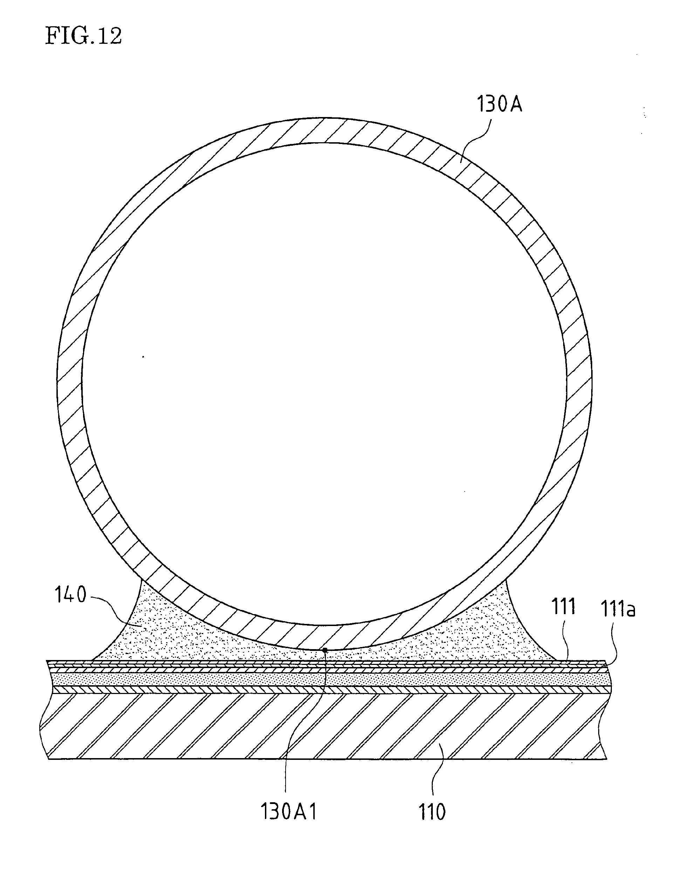

Now, in the solar cell module with such a configuration, a back film 111 that is a back face protective sheet arranged on the back face side of the solar cell module 100 has a three-layer structure consisting of, for example, PET/Al/PET (PET: polyethylene terephthalate) in order to ensure dampproof. Specifically, since PET alone can prevent intrusion of water droplets but cannot prevent intrusion of water vapor, an A1 layer llla, which is a metal layer (water-proof layer) for preventing intrusion of water vapor, is interposed in PET. Accordingly, as shown in FIG. 12, the bottom face 131 of the module support member 130 and the A1 layer 111a of the back film 111 are arranged in very close proximity to each other.

Meanwhile, the module support member 130 that is bonded to the back face side of this solar cell module main body 110 is formed from a metal material such as aluminum in order to ensure strength. Accordingly, discharge may occur between this module support member 130 and the A1 layer 111a of the back film 111 and therefore it is necessary to improve insulation therebetween. In this case, if a silicone resin is used as the above adhesive 140, the silicone resin serves as an insulating material. However, if the insulation is poor, discharge may occur when an impulse voltage test assuming lightning surge is carried out.

It is a well-known fact that, when the module support member 130 has a sharp-pointed part, discharge is likely to occur at that sharp-pointed part. That is, in the case of the above H-shaped module support member 130, a corner portion formed by the point of intersection of three faces, namely, the bottom face 131 and two adjacent side faces 132, is the sharpest-pointed corner portion, and accordingly there is the highest possibility that discharge may occur between this corner portion and the A1 layer 111a of the back film 111. In addition, both side edge portions of the bottom face 131 form corner portions 133 that are bent 90 degrees and accordingly, there is also a greater possibility of discharge occurring between these corner portions 133 and the A1 layer 111a of the back film 111. Furthermore, discharge may also occur between the A1 layer 111a of the back film 111 and portions of the side faces 132 of the module support member 130 that are not covered with the adhesive 140 if there is only a short distance therebetween.

Incidentally, Patent Document 1 described above specifies that, other than the H shape described above, the configuration of the module support member 130 may adopt other shapes such as a hollow cylindrical shape. When a hollow cylindrical shape is adopted, its cross-sectional shape is as shown in FIG. 12. Specifically, in the case of a module support member 130A having a hollow cylindrical shape, although no corner portion seemingly exists, there is a risk of discharge occurring at a.vertex.130A1 (in actuality, a straight line including this vertex and extending in the direction perpendicular to the paper) of the arc that is close to the back film 111. Also, in the case where the module support member 130A has a hollow cylindrical shape, it is necessary, in order to reliably bond and fix the module support member to the back film 111 with the adhesive 140, to apply a silicone resin as the adhesive in a mountain-like shape on both left and right sides of the vertex 130Al so as to cover the space that follows the arc of the outer peripheral face of the module support member 130. Accordingly, there is the problem that many parts of the resin are going to waste. Furthermore, although a thinner silicone resin is hardened in a shorter time and accordingly can contribute to bonding, there is the problem that a silicone resin applied in a mountain-like shape as described above is very difficult to harden and thus needs time to completely harden, or that such a silicone resin is not hardened completely and accordingly fails to give sufficient bonding strength. Furthermore, in the case of the module support member 130A having a hollow cylindrical shape, if the module support member 130A is pressed strongly against the back film 111 during bonding, the vertex 130A1 of the arc may be brought into contact with the back film 111. In this case, there is the problem that the advantage of insulation performance of the adhesive 140 is not used at all and increases the risk of discharge occurrence.

The present invention has been conceived to solve the above problems, and its object is to provide a solar cell module that reduces the risk of discharge occurrence and improves insulation by improving the shape of a corner portion formed by the face of each module support member that faces a back face protective sheet and each side face of the module support member, or the shape of a corner portion formed by the side faces of each module support member.

### Means for Solving the Problems

In order to solve the above problems, a solar cell module of the present invention is a solar cell module having a configuration in which at least one module support member is bonded with an adhesive to a back face protective sheet of a solar cell module main body in which a surface substrate, a solar cell, a sealing material, and the back face protective sheet are laminated in sequence one above another, wherein a corner portion formed by a face of the module support member that faces the back face protective sheet and each side face of the module support member is formed in a cut-out shape.

Also, in the solar cell module of the present invention, a corner portion formed by a face of the module support member that faces the back face protective sheet and two adjacent side faces of the module support member is formed in a cut-out shape.

Here, the shape of the module support member may be an H shape or an I shape. The cut-out shape of the corner portion may be a chamfered shape such as an R-chamfered or C-chamfered shape, or a stepped shape.

Specifically, if the corner portion formed by the face (bottom face) of the module support member that faces the back face protective sheet and each side face of the module support member is formed in a chamfered shape, the corner portion has no sharp-pointed part. This improves insulation between the module support member and a metal layer (A1 layer) of the back face protective sheet. In the case where the corner portion is formed in a stepped shape, although a sharp-pointed part remains, that part is located away from the back face protective sheet. Increasing the distance between a sharp-pointed part and the back face protective sheet in this way improves insulation between the module support member and the metal layer (Al layer) of the back face protective sheet.

Also, the feature of the solar cell module according to the present invention is that a corner portion formed by side faces of the module support member that stand upright from a face of the module support member that faces the back face protective sheet is cut into a polygonal or arc shape having an angle of more than 90 degrees.

Also, in the configuration according to the present invention, a cut-out part of the corner portion is covered with the adhesive. A configuration is also possible in which an area including a cut-out part of the corner portion and up to each side face is covered with the adhesive.

Covering the cut-out part of the corner portion with an adhesive having insulating properties, such as a silicone resin, in this way reliably improves insulation between the module support member and the metal layer (Al layer) of the back face protective sheet. In this case, if the configuration is such that an area up to the side faces beyond the cut-out part of the corner portion is further covered with the adhesive, insulation between the module support member and the metal layer (A1 layer) of the back face protective sheet can further be improved.

Here, if a viscous adhesive that is fluid during bonding is used as the adhesive, bonding pressure applied when the back face protective sheet and the module support member are bonded to each other causes the adhesive to flow to the cut-out part of the corner portion of the module support member and further to flow climbing up along the side faces of the corner portion, thus causing the cut-out part and the side faces to be covered with the adhesive. Note that favorable examples of such an adhesive include a silicone resin and an epoxy resin, and the adhesive may also be a bonding member using a base material (such as a double-sided tape). Furthermore, a kneading thing such as putty and paste may be used as an adhesive.

### Effects of the Invention

According to the present invention, a corner portion formed by the face of the module support member that faces the back face protective sheet and each side face of the module support member, and a corner portion formed by the face of the module support member that faces the back face protective sheet and two adjacent side faces of the module support member are formed in a cut-out shape. This eliminates sharp-pointed parts of the corner portions and consequently improves insulation between the module support member and the metal layer (A1 layer) of the back face protective sheet.

### Brief Description of Drawings

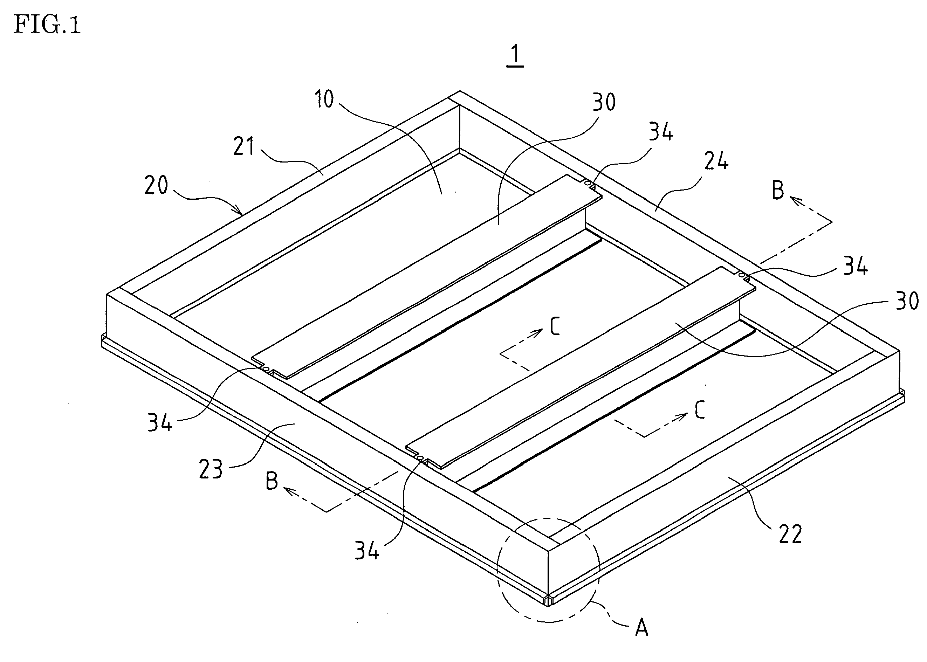

[FIG. 11 FIG. 1 is a perspective view showing the overall configuration of a solar cell module according to the present invention.
[FIG. 2] FIG. 2 is a cross-sectional view of an end portion of a solar cell module main body.
[FIG. 3] FIG. 3 is an exploded perspective view of a portion A in FIG. 1.
[FIG. 4] FIG. 4 is a cross-sectional view of a frame constituting a frame body.
[FIG. 5] FIG. 5 is a perspective view showing one end portion of a module support member at an increased size.
[FIG. 6] FIG. 6 is a cross-sectional view taken along line B-B in FIG. 1.
[FIG. 7] FIG. 7 is a cross-sectional view taken along line C-C in FIG. 1.
[FIG. 8] FIG. 8(a) is a partial enlarged cross-sectional view showing Embodiment 2 of a cut-out shape of a corner portion of a module support member, and FIG. 8(b) is a partial enlarged cross-sectional view showing Embodiment 3 of the cut-out shape of a corner portion of a module support member.
[FIG. 9] FIG. 9 is a partial enlarged perspective view showing Embodiment 3 of the cut-out shape of a corner portion of a module support member.
[FIG. 10] FIG. 10 is a diagram illustrating how to discharge an adhesive to a module support member with an adhesive discharge device.
[FIG. 11] FIG. 11(a) is a perspective view showing an example of the overall configuration of a conventional solar cell module, and FIG. 11(b) is a cross-sectional view taken along line D-D in FIG. 11(a).
[FIG. 12] FIG. 12 is a cross-sectional view showing a state in which a module support member having a hollow cylindrical shape is bonded to a back face protective sheet.

### Mode for Carrying out the Invention

Embodiments of the present invention will be described hereinafter with reference to the drawings.

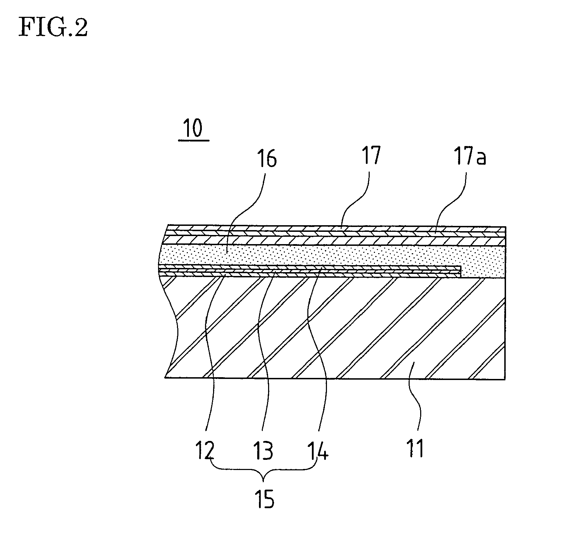

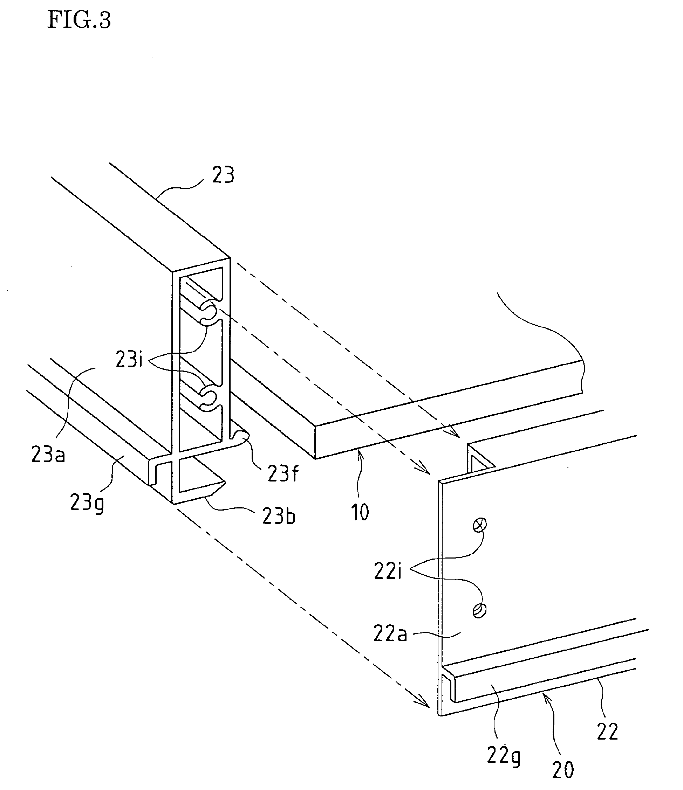

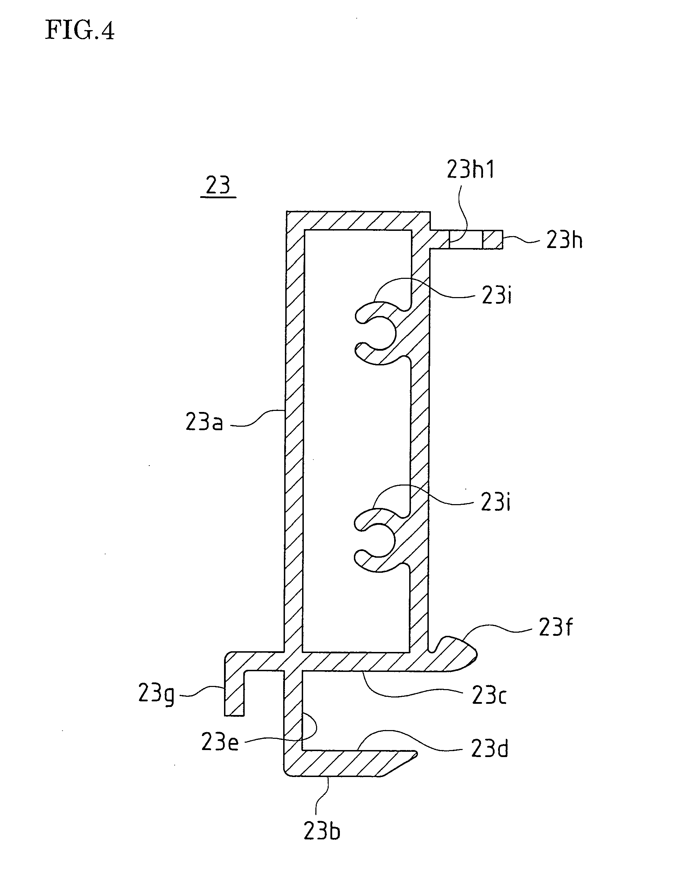

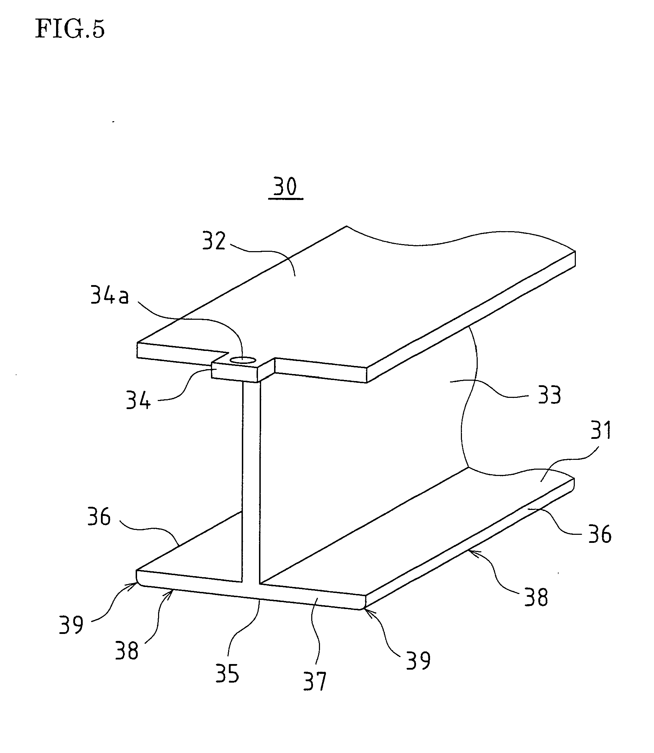

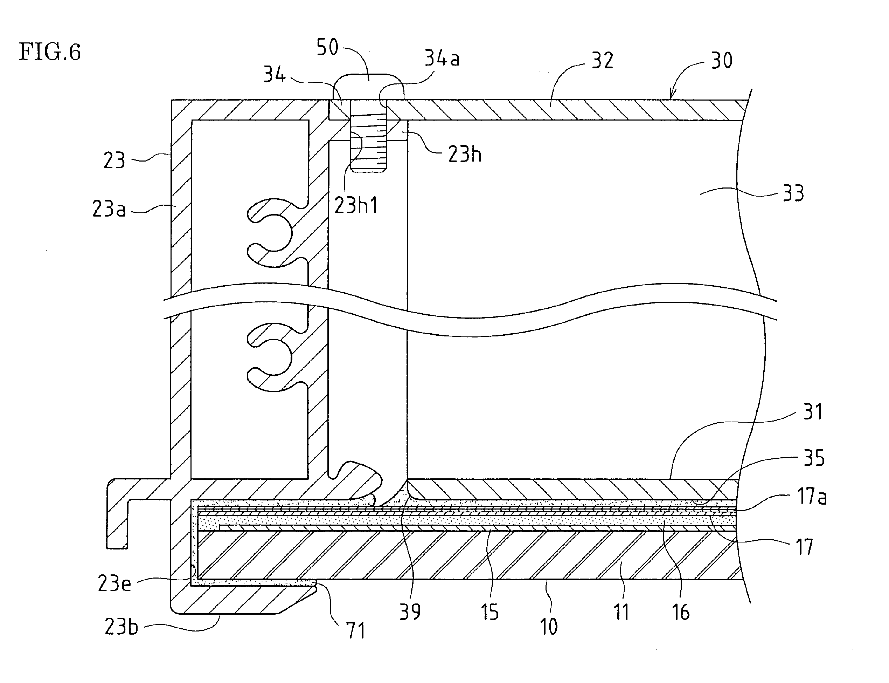

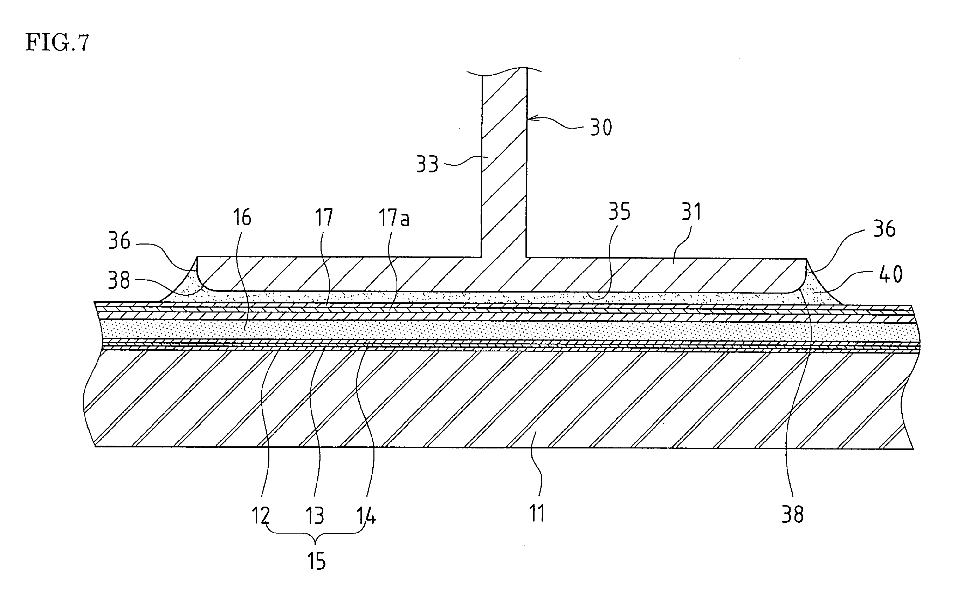

Embodiment 1 FIG. 1 is a perspective view showing the overall configuration of a solar cell module. Note that FIG. 1 is a perspective view of the solar cell module as viewed from the back face side, that is, a perspective view as viewed from the opposite side of a light-receiving face. FIG. 2 is a cross-sectional view of an end portion of a solar cell module main body, FIG. 3 is an exploded perspective view of a portion A in FIG. 1, FIG. 4 is a side view of a frame constituting a frame body, FIG. 5 is a perspective view showing one end portion of a module support member at an increased size, FIG. 6 is a cross-sectional view taken along line B-B in FIG. 1, and FIG. 7 is a cross-sectional view taken along line C-C in FIG. 1.

As shown in FIG. 1, a solar cell module 1 of the present embodiment is configured by a solar cell module main body 10, a frame body 20 that surrounds and holds the solar cell module main body, and two module support members 30 fixed to the frame body 20.

As shown in the partial enlarged cross-sectional view of the end portion in FIG. 2, the solar cell module main body 10 is configured by laminating, on a translucent insulating substrate (surface substrate) 11, a transparent electrode film 12 made of a transparent conducting film, a photoelectric conversion layer 13, and a back face electrode film 14 in this order, which constitute a solar cell 15, then laminating, on the back face electrode film 14, a sealing film (sealing material) 16 and a back film 17 serving as a back face protective sheet for providing weather resistance and high insulation, and then being sealed in its entirety by lamination so as to be integral in structure.

Examples of the translucent insulating substrate 11 include heat-resistant resins such as glass and polyimide. Examples of the transparent electrode film 12 include SnO₂, ZnO, and ITO. Examples of the photoelectric conversion layer 13 include silicone photoelectric conversion films such as amorphous silicon and microcrystalline silicone, and photoelectric conversion films based on a compound such as CdTe and CuInSe2. The back face electrode film 14 is formed from a ZnO transparent conducting film and a thin silver film, for example. The sealing film 16 is preferably a thermoplastic polymer film and, in particular, a sealing film made of, for example, an EVA (ethylene vinyl acetate) resin or a PVB (polyvinyl butyral) resin is optimal. The back film 17 has a three-layer structure consisting of, for example, PET/Al/PET (PET: polyethylene terephthalate) or PVF/Al/PVF (PVF: polyvinyl fluoride) resin film in order to ensure moisture resistance. Specifically, since PET or PVF alone can prevent intrusion of water droplets but cannot prevent intrusion of water vapor, an A1 layer, which is a metal layer (water-proof layer) for preventing intrusion of water vapor, is interposed in PET or PVF.

The frame body 20 is configured to hold the four sides of the above-described solar cell module main body 10 as shown in FIG. 3, and includes an upper frame 21, a lower frame 22, a left frame 23, and a right frame 24. Those frames 21, 22, 23, and 24 are integrally assembled, thus forming a frame shape. Note that a portion where the lower frame 22 and the left frame 23 are assembled with each other is shown in FIG. 3.

Each of the frames 21, 22, 23, and 24 is formed by extruding aluminum. The upper frame 21 holds the edge of the solar cell module main body 10 that is located on the ridge side of the house. The lower frame 22 holds the edge of the solar cell module main body 10 that is located on the eaves side of the house. The left and right frames 23 and 24 hold the left and right side edges of the solar cell module main body 10 and coupled to both ends of the upper frame 21 and the lower frame 22.

Next is a description of the basic structure of the frames 21, 22, 23, and 24. Since the frames 21, 22, 23, and 24 have a common basic structure, the below description is given of the cross-sectional shape of the left frame 2 with reference to FIG. 4. Note that the below description of the cross-sectional shape is given on the assumption that, in FIG. 4, the left side of the left frame 23 is referred to as the "outer side" constituting the outer edge of the solar cell module main body 10, and the right side of left frame 23 is referred to as the side supporting the solar cell module main body 10, i.e., the "inner side".

As shown in FIG. 4, the left frame 23 includes a frame main body 23a having a rectangular closed cross-section and is provided with an extended bent piece 23b that extends downward from the outer edge (left end in the drawing) of the underside of the frame main body 23a and then bends inward (right side in the drawing). This produces a groove portion 23e in which the outer peripheral end portion of the solar cell module main body 10 is fitted, between the underside 23c of the frame main body 23a and a horizontal portion 23d of the extended bent piece 23b. Also, a flange 23f that abuts against the upper face of the solar cell module main body 10 protrudes from the inner edge (right edge in the drawing) of the underside 23c of the frame main body 23a. Note that the width dimension of the groove portion 23e (vertical dimension in FIG. 4) is set to be slightly greater than the dimension of the thickness of the solar cell module main body 10 (vertical dimension in FIG. 2).

Also, a fixing rib piece 23h having a screw hole 23hl formed therein for mounting and fixing a module support member 30 with a screw or the like is formed at the upper portion of the inner side face of the frame main body 23a. This fixing rib piece 23h is provided corresponding to the mounting location of the module support member 30.

Also, an extended piece 23g that slightly extends in the horizontal direction and then bends downward protrudes from the outer side face (left side in the drawing) of the frame main body 23a. Note that in FIG. 3, reference numeral 23i denotes a screw-in portion provided with a screw hole in the left frame 23, and reference numeral 22i denotes a screw hole provided in the lower frame 22 in correspondence with the screw-in portion 23i. Specifically, screw-in portions are formed in the left and right frames 23 and 24, and screw holes corresponding to the screw-in portions are formed in the upper and lower frames 21 and 22.

FIG. 5 shows the shape of the end face of a module support member 30. In the present example, although the module support member 30 is H-shaped and includes a lower horizontal plate 31, an upper horizontal plate 32, and a vertical support plate 33 that supports the two horizontal plates, it may have other shapes such as an I shape or a hollow square prism. At both end portions of the upper horizontal plate 32 of the module support member 30, fixing rib pieces 34 (although only the rib piece on the near side is shown in FIG. 5) are formed for fixing the fixing rib piece 23h of the left frame 23 and the fixing rib piece (not shown) of the right frame 24 with screws. The fixing rib pieces 34 each have a screw hole 34a formed therein for inserting a screw.

The solar cell module 1 is assembled as described below using the members having the above-described structures.

First, an end-face sealing member 71 is fitted to the peripheral end portion of the solar cell module main body 10. This end-face sealing member 71 has a frame shape formed along the external shape of the end portion of the solar cell module main body 10 and is formed from an elastomeric resin, for example. Then, the groove portions 21e, 22e, 23e, and 24e of the front, back, left, and right frames 21, 22, 23, and 24 (note that only the groove portion 23e of the left frame 23 is shown and the other groove portions not shown in FIGS. 3, 4, and 6 in the present specification) are fitted to the peripheral end portion of the solar cell module main body 10 that has been fitted to the end-face sealing member 71 so that the screw-in portions of one of each adjacent pair of the frames face the screw holes of the other frame (in FIG. 3, the screw-in portions 23i of the left frame 23 face the screw holes 22i in the lower frame 22), and screws (not shown) are inserted therein so as to fixedly screw the upper, lower, left, and right frames integrally.

Next, in this condition, two module support members 30 are arranged in parallel at a predetermined interval from the back face side of the solar cell module main body 10. At this time, a viscous adhesive (such as a silicone resin or an epoxy resin) 40 has been applied in advance on the bottom faces 35 of the lower horizontal plates 31 of the module support members 30. The module support members 30 are fixed to the frame body 20 by placing the fixing rib pieces 34 formed at both end portions of the upper horizontal plates 32 of the module support members 30 on the fixing rib pieces 23h and 24h (note that the fixing rib pieces 24h of the right frame 24 are not shown) of the left and right frames 23 and 24, inserting screws 50 through the screw holes 34a formed in the fixing rib pieces 34 of the module support members 30, and screwing those screws into the screw holes 23hl and 24hl of the fixing rib pieces 23h and 24h formed in the left and right frames 23 and 24 (note that the screw holes 24h1 of the fixing rib piece 24h of the right frame 24 are not shown). At this time, bonding pressure applied when the module support members 30 are bonded to the back film 17 of the solar cell module main body 10 and subsequent screw pressure cause the viscous adhesive 40 to flow to the corner portions of the bottom face 35 of the lower horizontal plate 31 and further to flow climbing up along the side faces of the corner portions, thus causing the entire corner portions to be covered with the adhesive 40 (see FIG. 7).

Although such an assembled structure of the solar cell module 1 is identical to that of the conventional solar cell module shown in FIG. 11, the feature of the present embodiment lies in the shape of both corner portions of the bottom face 35 of the lower horizontal plate 31 of each module support member 30.

Specifically, as shown in FIGS. 5 to 7, with each module support member 30 of the present embodiment, a corner portion 38 formed by two faces, namely, the bottom face 35 of the lower horizontal plate 31 that faces the back film 17 of the solar cell module main body 10 and each of long side faces 36 and short side faces 37 thereof (see FIGS. 5 and 7) is formed in a cut-out shape. Also, a corner portion 39 formed by three faces, namely, the bottom face 35 of the lower horizontal plate 31 of the module support member 30 and two adjacent side faces thereof (the long side face 36 and the short side face 37) (see FIG. 6) is formed in a cut-out shape. More specifically, the corner portions 38 and 39 are chamfered into a round shape (this chamfered shape is referred to as "Embodiment 1").

Such a chamfered shape of the corner portions 38 and 39 formed by the bottom face 35 of the lower horizontal plate 31 of the module support member 30 and each of the long side faces 36 and the short side faces 37 eliminates sharp-pointed parts of the corner portions 38 and 39. This improves insulation between the module support member 30 and the Al layer 17a of the back film 17 serving as a metal layer.

Also, the present embodiment adopts a configuration in which the rounded corner portions 38 and 39 and an area including the corner portions 38 and 39 and up to the long side faces 36 and the short side faces 37 is covered with the adhesive 40. Covering the rounded corner portions 38 and 39 with the adhesive 40 having insulating properties such as a silicone resin or an epoxy resin in this way further improves insulation between the module support member 30 and the Al layer 17a of the back film 17.

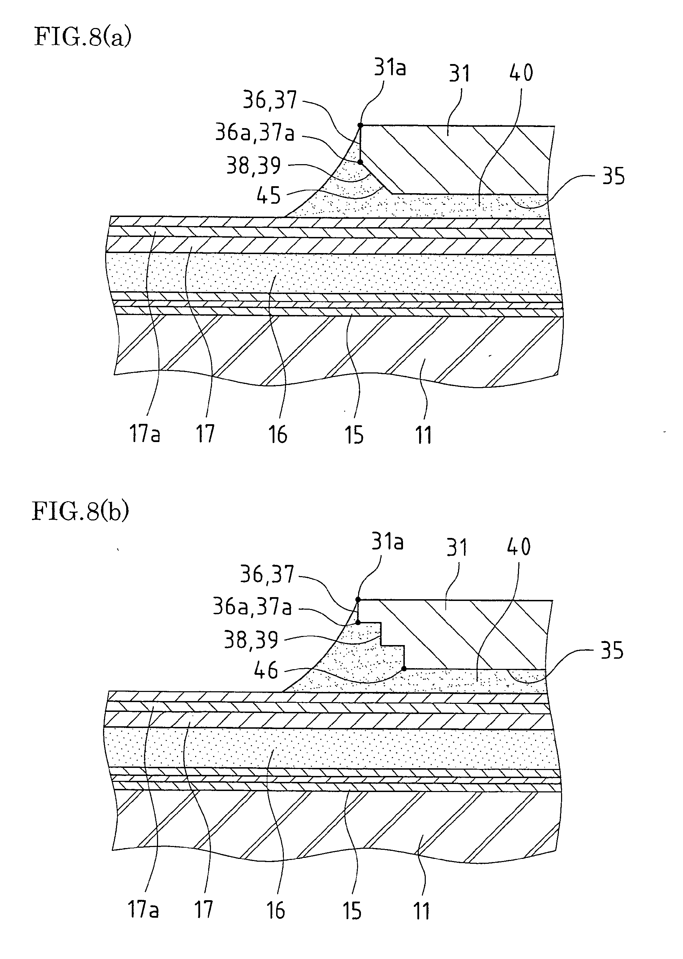

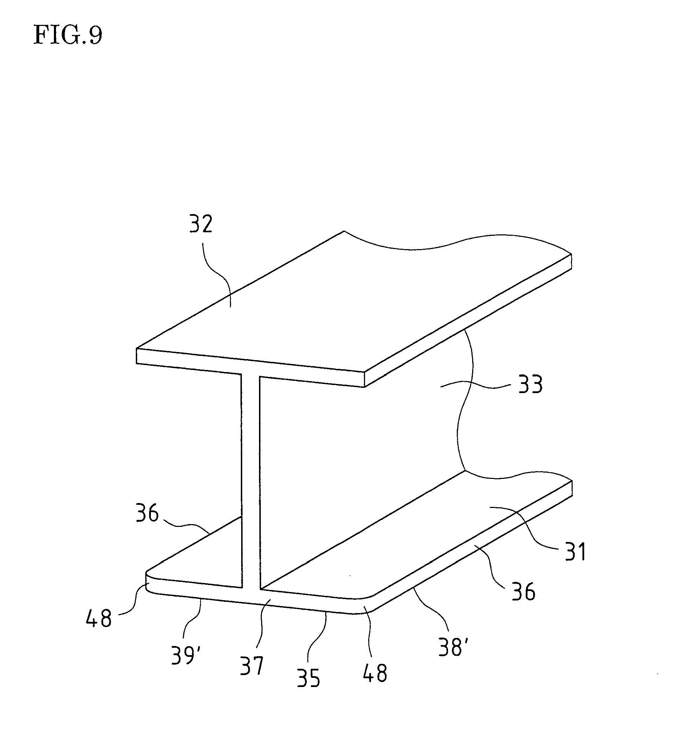

Other Embodiments FIGS. 8 and 9 show other embodiments of the chamfered shape of the corner portions 38 and 39 of a module support member 30. FIG. 8(a) shows the case where the chamfered shape is formed by C chamfering (this is referred to as "Embodiment 2"), FIG. 8(b) shows the case where the chamfered shape is a stepped shape (this is referred to as "Embodiment 3"), and FIG. 9 shows the case where corner portions formed by the side faces 36 and 37 that stand upright from the bottom face 35 of the lower horizontal plate 31 of the module support member 30 are cut out into a polygonal or arc shape having an angle of more than 90 degrees (this is referred to as "Embodiment 4").

Embodiment 2 In FIG. 8(a), the corner portions 38 and 39 of a module support member 30 are formed by C chamfering, i.e., they are diagonally cut out from a side face portion 36a or 37a that is slightly below an upper corner portion 31a of the lower horizontal plate 31 of the module support member 30 toward the bottom face 35. Although such a diagonal cut produces a corner portion located at the lower side of a resultant C-chamfered face 45, that is, a corner portion at a location where the C-chamfered face 45 is adjacent to the bottom face 35, the angle of such a corner portion is approximately 135 degrees that is greater than the angle (90 degrees) of a corner portion of the module support member 130 in the conventional solar cell module shown in FIG. 11, and accordingly the risk of discharge occurrence is reduced by the amount of difference in angle. Although a similar corner portion is also formed at a location where the C-chamfered face 45 is adjacent to each side face 36 or 37, the position of such a corner portion is away from the back film 17 by the amount of C chamfering and accordingly the risk of discharge occurrence is reduced by the amount of distance away from the back film 17. Furthermore, in the present embodiment, since the C-chamfered face 45 and an area including the C-chamfered face 45 and up to the side faces 36 and 37 are covered with the adhesive 40, insulation between the module support member 30 and the Al layer 17a of the back film 17 can further be improved.

Embodiment 3 In FIG. 8(b), the corner portions 38 and 39 of a module support member 30 are cut out into a stepped shape from a side face portion 36a or 37a that is slightly below an upper corner portion 31a of the lower horizontal plate 31 of the module support member 30 toward the bottom face 35. Note that in the present example, although the stepped shape is formed of two steps, the number of steps may be one or more than two. In the case where a corner portion is formed in such a stepped shape, although 90-degree corner portions exist as in the case of the module support member 130 of the conventional solar cell module shown in FIG. 11, the corner portions other than the lowermost corner portion 46 are away from the back film 17 because of the stepped shape and accordingly, the risk of discharge occurrence is reduced by the amount of distance away from the back film 17. Although the distance between the lowermost corner portion 46 and the back film 17 is the same as the distance between the back film 111 and a corner portion of the module support member 130 of the conventional solar cell module shown in FIG. 11, the lowermost corner portion in the stepped shape is located inward away from the side face 36 or 37 of the lower horizontal plate 31 and is thus reliably covered with the adhesive 40, whereas the corner portions of the module support member 130 of the conventional solar cell module are exposed without being covered with the adhesive. Accordingly, insulation between the lowermost corner portion and the back film 17 can be improved. Furthermore, in the present embodiment, since an area including the uppermost corner portion in the stepped shape and up to the side faces 36 and 37 is covered with the adhesive 40, insulation between the module support member 30 and the Al layer 17a of the back film 17 can further be improved.

Embodiment 4 In FIG. 9, corner portions 38' and 39' formed by the bottom face 35 of the lower horizontal plate 31 of the module support member 30 and the side faces 36 and 37 are not cut out and remain right-angled, whereas four corner portions 48 formed by the side faces 36 and 37 that stand upright from the bottom face 35 of the lower horizontal plate 31 of the module support member 30 are cut out into a polygonal or arc shape having an angle of more than 90 degrees (in FIG. 9, an arc shape is shown). According to Embodiment 4, although the corner portions 38' and 39' formed by the bottom face 35 and the side faces 36 and 37 remain right-angled and accordingly the risk of discharge occurrence at those portions is not eliminated, the locations with the highest risk of discharge occurrence are four sharp-pointed corners and in Embodiment 4, those four corners are formed in a polygonal or arc shape having an angle of more than 90 degrees so as to reduce the risk of discharge occurrence at those parts. Furthermore, in the present embodiment, since the entire side faces 36 and 37 including the corner portions 48 are covered with the adhesive 40, insulation between the module support member 30 and the A1 layer 17a of the back film 17 can be improved.

Note that although Embodiments 1 to 3 above have illustrated three shapes, namely, an R-chamfered shape, a C-chamfered shape, and a stepped shape, as examples of the cut-out shape of a corner portion at the peripheral edge of the bottom face 35 of the lower horizontal plate 31 of a module support member 30, the cut-out shape is not limited to those three shapes, and it includes all cut-out shapes that are cut out into any shape (such as a concave shape, a waveform shape, and a polygonal shape).

Also, in the above-described embodiments, the configuration has been illustrated in which, during assembly of the solar cell module 1, bonding pressure applied when a module support member 30 is bonded to the back film 17 and subsequent screw pressure cause a viscous adhesive applied to the bottom face 35 of the lower horizontal plate 31 of the module support member 30 to flow to the corner portions of the bottom face 35 of the lower horizontal plate 31 and further to the side faces of the corner portions. However, in the case where the viscous adhesive 40 is applied using an adhesive discharge device on the bottom face 35 of the lower horizontal plate 31 of a module support member 30, the adhesive may be applied in advance so as to cover the area from the bottom face 35 of the lower horizontal plate 31 to the side faces 36 and 37.

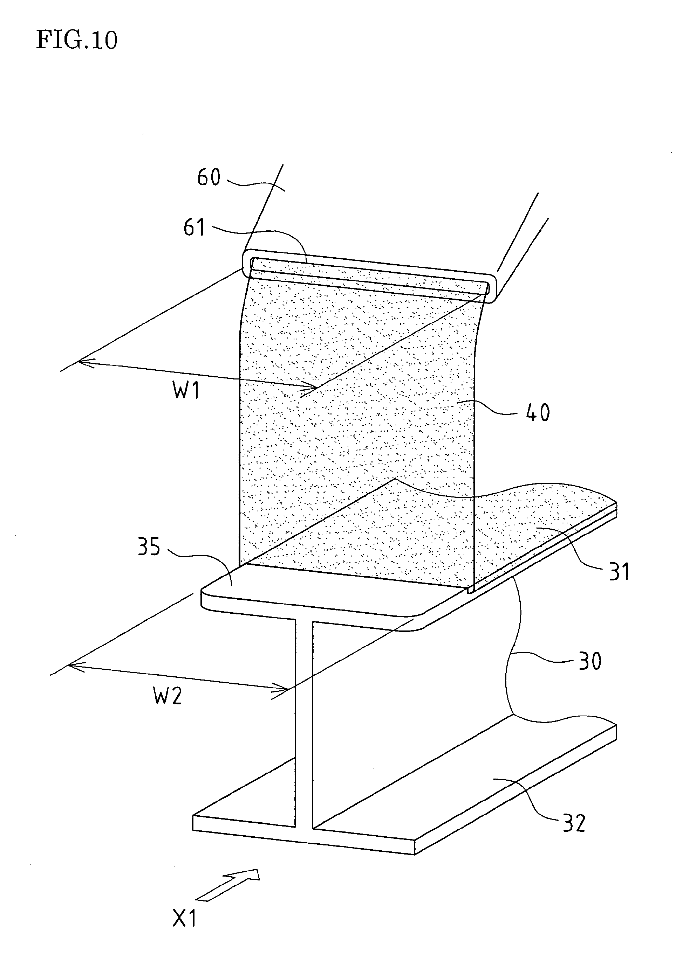

Specifically, as shown in FIG. 10, the longitudinal length W1 of a resin discharge port 61 of an adhesive discharge device 60 (the widthwise length of the module support members 30) is set to be a predetermined length longer than the width W2 of the lower horizontal plate 31 of a module support member 30 (W1>W2). Then, the adhesive 40 such as a silicone resin is discharged across the width W1 from the resin discharge port 61 when the module support member 30 is passed through under the resin discharge port 61 of the adhesive discharge device 60 in a direction X1 shown in the drawing, with the bottom face 35 of the lower horizontal plate 31 facing up. This allows the adhesive (silicone resin) to be applied to an area from the bottom face 35 of the lower horizontal plate 31 to the side faces 36 and 37.

Also, although the case where two module support members 30 are arranged in parallel is illustrated in the above embodiments, the number of module support members 30 to be arranged is not limited to two, and may be one or more than two depending on the size of the solar cell module itself or the required strength. In addition, the layout of module support members 30 is not limited to just a simple parallel arrangement, and it may be various other arrangements such as a cross arrangement or a rhombus arrangement.

Furthermore, although a silicone resin, an epoxy resin, or the like has been taken as an example of the adhesive 40 in the above embodiments, an adhesive member using a base material (such as a double-sided tape) may be used. Some double-sided tapes, such as "HYPERJOINT 8020" manufactured by Nitto Denko Cooperation, have flexibility in themselves along their thickness, and use of a double-sided tape made of such a material makes it possible to ensure fluidity of the above-described adhesive.

Other than such an liquid adhesive and a double-sided tape, a kneading thing such as putty and paste that is used to repair water leakage, for example, may be used as an adhesive.

The present invention can be reduced to practice in various other forms without departing from its spirit or essential features. For this reason, the above-described exemplary embodiments are to all intents and purposes merely illustrative and should not be construed as limiting. The scope of the present invention is defined by the claims and is not in any way restricted by the descriptions of the specification. Furthermore, all variations and modifications of the claims within the scope of equivalency fall within the scope of the present invention.

### Industrial Applicability

The present invention can be suitably used as a solar cell module that ensures strength, reduces the risk of discharge occurrence, and improves insulation.

### Description of Reference Numerals

- 1: Solar cell module
- 10: Solar cell module main body
- 11: Translucent insulating substrate
- 12: Transparent electrode film
- 13: Photoelectric conversion layer
- 14: Back face electrode film
- 15: Solar cell
- 16: Sealing film
- 17: Back film (back face protective sheet)
- 17a: A1 layer (metal layer)
- 20: Frame body
- 21: Upper frame
- 22: Lower frame
- 23: Left frame
- 24: Right frame
- 30: Module support member
- 31: Lower horizontal plate
- 32: Upper horizontal plate
- 33: Vertical support plate
- 34: Fixing rib piece
- 34a: Screw hole
- 35: Bottom face
- 36: Long side face (side face)
- 37: Short side face (side face)
- 38, 39: Corner portion
- 40: Adhesive
- 50: Screw
- 60: Adhesive discharge device
- 61: Resin discharge port

## Claims

1. A solar cell module having a configuration in which at least one module support member is bonded with an adhesive to a back face protective sheet of a solar cell module main body in which a surface substrate, a solar cell, a sealing material, and the back face protective sheet are laminated in sequence one above another, wherein
a corner portion formed by a face of the module support member that faces the back face protective sheet and each side face of the module support member is formed in a cut-out shape.

2. The solar cell module according to claim 1, wherein a corner portion formed by a face of the module support member that faces the back face protective sheet and two adjacent side faces of the module support member is formed in a cut-out shape.

3. The solar cell module according to claim 1, wherein the cut-out shape of the corner portion is a chamfered shape.

4. The solar cell module according to claim 1, wherein the cut-out shape of the corner portion is a stepped shape.

5. A solar cell module having a configuration in which at least one module support member is bonded with an adhesive to a back face protective sheet of a solar cell module main body in which a surface substrate, a solar cell, a sealing material, and the back face protective sheet are laminated in sequence one above another, wherein
a corner portion formed by side faces of the module support member that stand upright from a face of the module support member that faces the back face protective sheet is cut out in a polygonal or arc shape having an angle of more than 90 degrees.

6. The solar cell module according to any one of claims 1 to 5, wherein a cut-out part of the corner portion is covered with the adhesive.

7. The solar cell module according to any one of claims 1 to 4, wherein an area including a cut-out part of the corner portion and up to the side face is covered with the adhesive.

8. The solar cell module according to claim 5, wherein an area up to the side faces including the corner portion is covered with the adhesive.

9. The solar cell module according to claim 1 or 5, wherein the adhesive has viscosity during bonding.

10. The solar cell module according to claim 9, wherein the adhesive is a silicone resin or an epoxy resin.

11. The solar cell module according to claim 1 or 5, wherein the adhesive is a bonding member using a base material.
